# EUROPEAN PATENT SPECIFICATION

(11) **EP 2 558 610 B1**
(45) Date of publication and mention of the grant of the patent: **10.12.2014**
(21) Application number: 11721375.1
(22) Date of filing: 20.03.2011
(51) Int. Cl.: C23C 14/35, C23C 28/00, C23C 30/00

(54) **HARD CARBON COATING AND METHOD OF FORMING THE SAME**
HARTKOHLENSTOFFBESCHICHTUNG UND VERFAHREN ZUR IHRER HERSTELLUNG
REVÊTEMENT DE CARBONE DUR ET PROCÉDÉ DE FORMATION DE CELUI-CI

(30) Priority: 14.04.2010 IL 20509010
(43) Date of publication of application: 20.02.2013
(73) Proprietor: Iscar Ltd., 24959 Tefen (IL)
(72) Inventor: LAYYOUS, Albir A., 25140 Me'ilya (IL)
(74) Representative: Vossius & Partner
(86) International application number: PCT/IL2011/000264
(87) International publication number: WO 2011/128889

(56) References cited:
- EP-A1- 2 295 616
- EP-A2- 0 503 822
- JP-A- 2005 213 613
- US-A1- 2007 048 454
- YULEI ZHANG, HEJUN LI, XINFA QIANG AND KEZHI LI: "Oxidation protective C/SiC/Si-SiC Multilaer Coating for Carbon/Carbon Composites Applying at 1873 K", J. MATERR. SCI. TECHNOL., vol. 26, no. 12, 2 April 2010 (2010-04-02) , pages 1139-1142, XP002651384,
- B.H. LUNG, M.J. CHIANG, M.H. HON: "Effect of gradient a-SiCx interlayer on adhesion of DLC films", MATERIALS CHEMISTRY AND PHYSICS, vol. 72, 2001, pages 163-166, XP002651385,
- LAIDANI N ET AL: "Spectroscopic characterization of thermally treated carbon-rich Si1-xCx films", THIN SOLID FILMS, ELSEVIER-SEQUOIA S.A. LAUSANNE, CH, vol. 223, no. 1, 15 January 1993 (1993-01-15), pages 114-121, XP024626510, ISSN: 0040-6090, DOI: DOI:10.1016/0040-6090(93)90734-7 [retrieved on 1993-01-15]
- XU X J ET AL: "Improvement of Tribological Behaviour of Biomedical Nanocrystalline Titanium by Magnetron Sputtered DLC/SiC Double Layer Films", MATERIALS SCIENCE FORUM, AEDERMANNSFDORF, CH, vol. 610-613, no. Part 2, 1 January 2009 (2009-01-01), pages 1026-1033, XP009150410, ISSN: 0255-5476

## Description

### FIELD OF THE INVENTION

The present invention relates to a hard carbon coating that is used in applications which require excellent wear resistance, such as cutting tools and sliding members, and a method of forming the same.

### BACKGROUND OF THE INVENTION

Diamond, having exceptional properties of high hardness, high thermal conductivity, high compressive strength, wear resistance, high corrosion-resistance, and a low coefficient of friction, is a suitable coating for cutting tools particularly nonferrous metals such as A1 alloys, graphite or ceramics. Cutting tools with cutting edges coated with a diamond layer or with a diamond like coating (DLC) are superior in strength, wear resistance and heat resistance, minimal adhesion and built-up edge generating fine workpiece surface finishes. Throughout the description and claims, a diamond layer is a layer of carbon in the sp3 phase, a DLC layer is a layer of carbon in both sp2 and sp3 phases with a sp3/sp2 ratio of at least 50%, and a hard carbon coating is a coating having at least one diamond layer or at least one DLC layer.

Hard metal cutting tools coated with a hard carbon coating usually fail due to insufficient strength of the interface between the hard carbon coating and the substrate. One contributing factor is the difference of the coefficient of thermal expansion (CTE). The CTE of cutting tools substrates such as cemented carbide, HSS, etc., is greater than the CTE of hard carbon coatings consequently the substrate shrinks more than the hard carbon coating when cooled from the deposition temperature, leading to high level of compressive residual stress of the hard carbon coating usually resulting in delamination of the coating.

Another cause of insufficient strength of the interface is that Fe and Co are both catalysts converting hard carbon into graphite so that when hard carbon is deposited on, for example, cemented carbide with a cobalt binder, a layer of graphite first grows followed by a hard carbon layer.

Diamond coatings are not chemically bonded to the substrate surface and the coating relies on a mechanical bond with the diamond film interlocking with WC grains on the tool surface. Producers of diamond coated tools usually etch the substrate's surface to expose grains of WC before coating and diamond films on cemented carbide tools are generally coarse-grained to provide the needed adhesion to the substrate. Coarse-grained (faceted) diamond, however, has disadvantages, including the inability to produce a very smooth workpiece surface finish. One solution to this problem is to etch away the Co binder from the surface layers of cemented carbide by various techniques, including acid etching. However, etching of Co binder reduces the interfacial surface strength of the cemented carbide article and the diamond coating and substantially reduces the strength of the hard metal substrate itself. Etching of Co from sharp edges will drastically reduce the sharp edge strength and thus greatly increase the likelihood of failure of the cutting tool during machining

Another known solution to the problem of adhesion of the hard coating to the substrate is to have a ceramic and/or metallic intermediate adhesion layer between the substrate and the hard carbon layer acting as diffusion barriers. For example JP 7026367 discloses one or more layers formed by a PVD method constituted of the carbides, nitrides and carbon nitrides of 4a, 5a and 6a group metals and Al₂O₃. JP 59170262 discloses a single layer of one kind of compound selected among the carbides, nitrides, carbonitrides, and oxycarbonitrides of the IVa, Va and VIa group metals in the periodic table, Si and B or a double layer of two or more kinds of compounds selected among said compounds. However, these ceramic interfacial layers do not form chemical bonds with hard carbon and therefore, do not provide good adhesion between the hard carbon coating and the substrate. Consequently, adhesion of hard carbon coatings to substrates remains a problem. Another example of an adhesion layer may be found in CA2150739 that discloses a process for coating a substrate with a polycrystalline diamond coating applied by CVD that are first coated with thin intermediate layers applied by CVD of which the diamond adherence layer is SiC or Si3N4.

Coatings incorporating CVD layers characterized by thermal cracks and residual tensile stress and an outermost PVD layer in a state of residual compressive stress are known, for example, from US 5143488, US 5364209, US5250367, and US 5266388. The deposition of the PVD layer over the CVD layer(s) partially restores the loss in transverse rupture strength to the coating. These coatings are usually deposited over carbide enriched substrates and the layers of these coatings are typically selected from carbides, nitrides, carbonitrides, borides, boronitrides, oxycarbides, of Ti, Zr, and Hf, and the oxides, and oxynitrides of Al.

### SUMMARY OF THE INVENTION

In accordance with the present invention there is provided a coated member comprising a coating and a substrate, the coating comprising at least one intermediate layer and at least one hard carbon layer; wherein the hard carbon layer comprises diamond or DLC and forms the outermost layer of the coating;
the intermediate layer comprises a PVD-formed layer having a composition of SiₓC_{1-x-y-z}N_{y}M_{z} (where 0.4 ≤ x ≤ 0.6, 0 ≤ y ≤ 0.1, and 0 ≤ z ≤ 0.2), wherein Si and C are essential components and M is one or more elements selected from the group consisting of: Ti, Zr, Hf, V, Nb, Ta, Cr, Mo, W, Y, B, Al and Ru; and a half-value width of an SiC peak observed at 34° to 36° of diffraction angle when X-ray diffraction (XRD) is carried by using a CuKα ray is 3° or less.

In accordance with some embodiments, the coating comprises a laminated sequence comprising alternating layers of an intermediate layer and a hard carbon layer, the laminated sequence including a plurality of intermediate layers and a plurality of hard carbon layers.

Typically, all layers of the plurality of intermediate layers arefrom 10 nm to 10 µm; and all layers of the plurality of hard carbon layers are from 0.1 µm to 50 µm.

Optionally, at least two layers of the plurality of intermediate layers have different compositions; and/or at least two layers of the plurality of hard carbon layers have different compositions.

In accordance with some embodiments, the coating further comprises at least one first layer comprising one or more metals selected from the group consisting of Ti, Zr, Hf, V, Nb, Ta, Cr, Mo, W; and optionally further comprising one or more elements selected from the group consisting of: Si, Al, Y, B, N and C.

In accordance with some embodiments, the coating comprises a multi-layered structure comprising a plurality of first layers and a plurality of intermediate layers; wherein the outermost layer of the multi-layer structure is the intermediate layer.

Optionally, the multi-layered structure comprises at least two layers of the plurality of first layers of different compositions and/or at least two layers of the plurality of intermediate layers of different compositions.

Typically, all layers of the plurality of first layers of the multi-layered structure are from 5 nm to 10 µm.

Optionally, all layers of the plurality of first layers comprises two or more sublayers of different compositions.

Optionally, the coating comprises a laminated sequence comprising alternating layers of an intermediate layer and a hard carbon layer. The laminated sequence including a plurality of intermediate layers and a plurality of hard carbon; the laminated sequence is over the multi-layered structure. The outermost layer of the laminated sequence is one of said hard carbon layers and is also is the outermost layer of the coating.

Typically, the substrate is selected from the group consisting of: high speed steel, hard metals, oxide ceramics, carbide ceramics, boride ceramics, super abrasive materials, PcBN, PCD, and cermets or combinations thereof.

Typically, the member is selected from the group consisting of cutting tools, cutting inserts, jigs and friction members.

In another aspect of the invention, there is provided a method of making a coated member comprising a substrate and a coating. The method comprises the steps of:
(a) depositing, by means of a PVD method, an intermediate layer over the substrate the intermediate layer having a composition of SiₓC_{1-x-y-z}N_{y}M_{z} (where 0.4 ≤ x ≤ 0.6, 0 ≤ y ≤ 0.1, and 0 ≤ z ≤ 0.2), where M is one or more elements selected from the group consisting of: Ti, Zr, Hf, V, Nb, Ta, Cr, Mo, W, Y, B, Al and Ru, such that a half-value width of an SiC peak observed at 34° to 36° of diffraction angle when X-ray diffraction (XRD) is carried by using a CuKα ray is 3° or less:
   wherein, during PVD deposition, the substrate being kept at a predetermined temperature between 400°C and 800 °C and a predetermined bias voltage of -30 V to - 300 V being applied to the substrate; and
(b) depositing a hard carbon layer on the intermediate layer, the hard carbon layer comprising diamond or DLC.

Optionally, the PVD method is a magnetron sputtering method.

Optionally, the method further comprises prior to carrying out step (a), (i) depositing a first layer over the substrate, wherein the first layer comprising one or more metals selected from the group consisting of Ti, Zr, Hf, V, Nb, Ta, Cr, Mo, W; wherein the thickness of the first layer is from 5 nm to 10 µm;

Optionally, the at least one first layer further comprises one or more elements selected from the group consisting of Si, Al, Y, B, N and C.

Optionally, the method further comprises after step (a) and before step (b), alternatingly depositing additional first layers and intermediate layers and/or after step (b), alternatingly depositing additional intermediate layers and hard carbon layers, wherein the final layer deposited is a hard carbon layer.

### BRIEF DESCRIPTION OF DRAWINGS

FIG. 1 is a schematic sectional view of a member coated with a coating according to a first embodiment of the invention,
Fig. 2a and Fig 2b are schematic sectional views of members coated with coatings according to a second embodiment of the invention,
Fig. 3 is a schematic sectional view of a member coated with a coating according to a third embodiment of the invention, and
Fig. 4 is a schematic sectional view of a member coated with a coating according to a fourth embodiment of the invention.

### DETAILED DESCRIPTION OF THE INVENTION

The hard carbon coating of the invention may be deposited in any of the methods of hard carbon coating known in the art such as, by way of example hot filament CVD, combustion flame method, ECR (electron cyclotron resonance), or plasma assisted CVD (PCVD). The hard carbon coating may be ultrananocrystalline diamond, coarse grained diamond, or DLC.

Throughout the description and claims, the layer that is closest to the substrate is defined as an innermost layer and the layer that is farthest from the substrate is defined as an outermost layer.

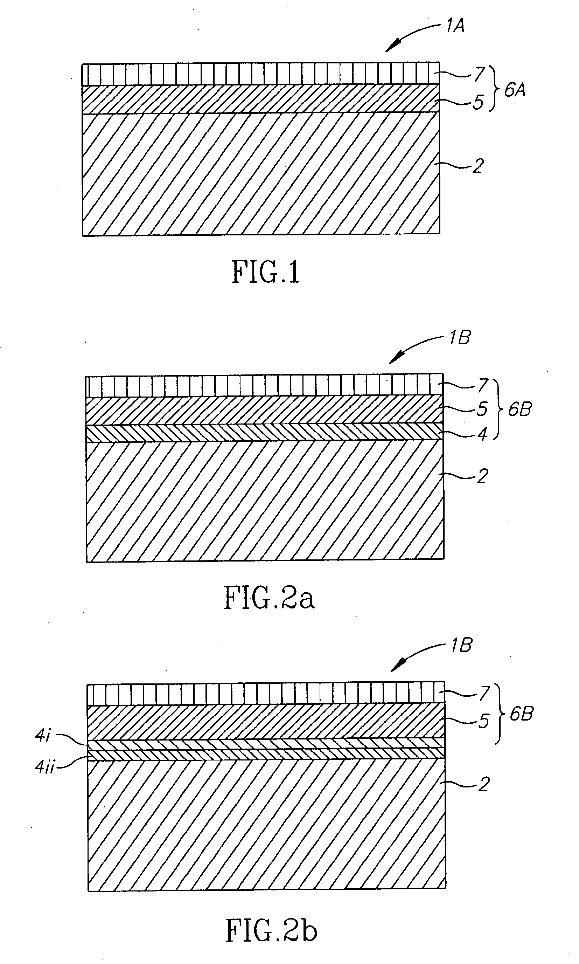

FIG. 1 is a schematic sectional view of a member 1A according to a first embodiment of the invention. The member 1 A has a substrate 2 coated with a coating 6A comprising an intermediate layer 5 and an outermost hard carbon layer 7.

Metallic materials such as iron-base alloys and hard metals, or cermets, ceramics, or super abrasives are suitably used as the substrate 2. In embodiments wherein the member 1A is used as a cutting tool, the hard metal is suitably used as the substrate 2.

The intermediate layer 5 has a composition of SiₓC_{1x-y-z}N_{y}M_{z} (where 0.4 ≤ x ≤ 0.6, 0 ≤ y ≤ 0.1, and 0 ≤ z ≤ 0.2) having Si (silicon) and C (carbon) as its essential components and N (nitride) and an element M as its optional components. The element M is one or more elements selected from group consisting of Ti, Zr, Hf, V, Nb, Ta, Cr, Mo, W, Y, B, Al and Ru. The intermediate layer may have a compositional gradient with regard to the concentration of C, N, and/or M in the direction from the outer surface of the coating towards the substrate. The gradient being such that there is a difference between the average concentration of C, N, and/or M at the outermost portion of the intermediate layer and the average concentration of C, N, and/or M at the innermost portion of the intermediate layer.

It is noted that "crystalline" is those whose half-value width (FMHM: Full Width Half Maximum) of an SiC peak observed at 34° to 36° of diffraction angle 2θ when X-ray diffraction (XRD) is carried by using a CuKα ray is 3° or less and includes not only those substantially considered to be the SiC crystal but also those forming a compound structure including the SiC crystal and the amorphous SiC. Specifically, the peak observed at the 34° to 36° corresponds to a peak of a [111] face of a cubical crystal SiC.

The intermediate layer 5 is formed by using PVD methods described in WO 2009/150887. The intermediate layer 5 may be a thin layer of 10 nm or may be a thick layer of up to 10µm.

The hard carbon layer 7 may be deposited according to CVD methods known in the art. The hard carbon layer 7 may be a thin layer of 0.1 µm, or may be a thick layer of up to 50µm.

SiC (silicon carbide) has a hardness of at least 40 GPa and is excellent in oxidation resistance and wear resistance. Crystalline SiC film is formed essentially without cracks by controlling film forming conditions of a PVD method (disclosed in WO 2009/150887). This film has been found to be a good adhesion interface layer between the substrate or a coated substrate and a hard carbon layer or between two hard carbon layers. As explained above, the cobalt and/or nickel that is the binder in cemented carbide, is a catalyst converting hard carbon into graphite. XRD analysis shows a CoSi phase found in SiC layers deposited over cemented carbide substrates by CVD method, even when there are layers of TiN and/or TiCN between the substrate and the SiC layer. The temperature of the CVD method is between 800°C and 1200°C while the temperature of the PVD method is between 400°C and 800°C. It has been now been found that the SiC film disclosed in WO 2009/150887 is greatly superior in its ability to serve as a diffusion barrier to elements present in the substrate, including cobalt, over known CVD SiC layers.

Fig. 2a and Fig 2b are schematic sectional views of a member 1B according to a second embodiment of the invention. The substrate 2 of the member 1B is coated with a coating 6B. The coating 6B has three layers: an innermost first layer 4 formed on the surface of the substrate 2, an intermediate layer 5 provided on the first layer 4, and a hard carbon layer 7 formed on the intermediate layer 5.

The substrate 2 of the member 1B is the similar to the substrate 2 of member 1 A described above. The intermediate layer 5 and hard carbon layer 7 of coating 6B are substantially the same with the intermediate layer 5 and hard carbon layer 7 of coating 6A described above.

The first layer 4 comprises one or more metals selected from the group of essential components consisting of Ti, Zr, Hf, V, Nb, Ta, Cr, Mo, and W and optionally further comprising and one or more elements selected from the group of elective components consisting of Si, Al, Y and B. In some embodiments of the invention the first layer 4 may be metallic or may be a mixture of essential and elective components. In other embodiments, the first layer 4 is ceramic and further comprises one or both nonmetal elements of N and C. The first layer 4 described above has an excellent adhesiveness with respect to the substrate 2. The intermediate layer 5 has excellent adhesiveness to the first layer 4. Accordingly, the coating 6B shows the excellent adhesiveness to the substrate 2 by providing the first layer 4 as the innermost layer of coating 6B. That is, the member 1B has improved adhesiveness between the substrate 2 and the hard carbon layer 7 to that of the aforementioned member 1A. Cutting tools, jigs and friction members to which the configuration of the member 1B is applied present an excellent durability.

The first layer 4 preferably has one or more of Ti and Cr as essential components and one or more elements selected from Y, Al and Si as elective components and in some embodiments is a nitride. The first layer 4 is preferably any one of Ti, Cr, TiN, CrN, TiC, TiAIN, CrAlN, TiCrAlN, TiCrAlSiN, TiAlSiN, and TiCrAlSiYN. Of these, Ti, CrN, TiAIN, CrAlN, TiCrAlN, TiCrAlSiN, TiAlSiN, and TiCrAlSiYN are especially in some applications for cutting tools. First layers 4 containing Al have improved oxidation resistance at high temperatures, such as those cutting tools attain while cutting resulting in improved cutting performance.

The first layer 4 is preferably at least 0.2 µm, more preferably at least 0.5 µm. As seen in Fig. 2b, in some embodiments, the first layer 4 has two or more sublayers 4i, 4ii, etc, whereas adjacent sublayers have different compositions. The sublayers may all have the same thickness or in some embodiments one or more of the sublayers may have unique thicknesses. The thickness of each of the sublayers of the first layer 4 is preferably at least 5 nm.

The first layer 4 may be formed by known methods such as an arc ion plating method or a CVD method. The intermediate layer 5 is formed on the first layer 4 by means of magnetron sputtering. It is preferable to use a film forming apparatus that can selectively perform the magnetron sputtering or the arc ion plating to the substrate mounted in its chamber.

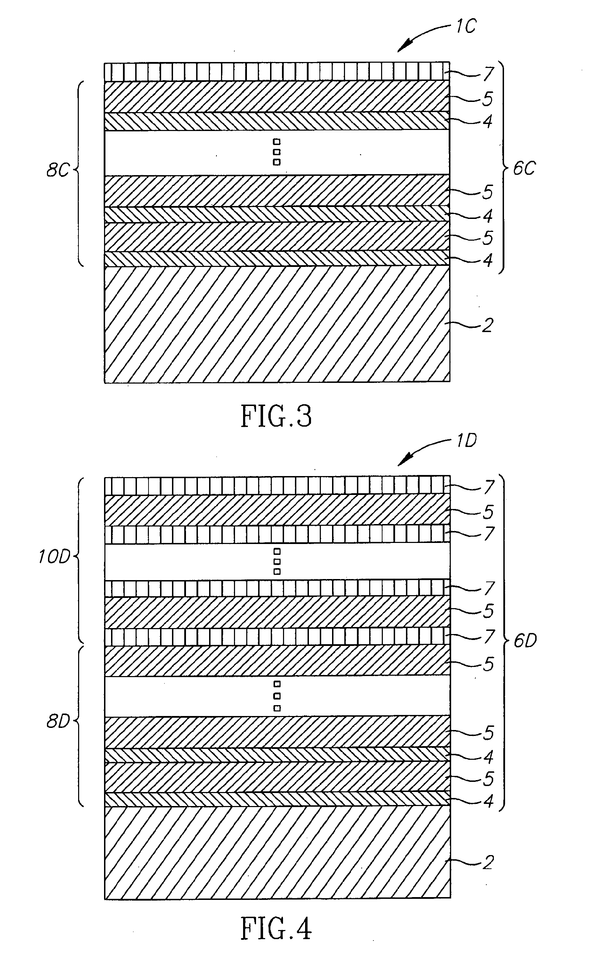

Fig. 3 is a schematic sectional view of a member 1 C according to a third embodiment of the invention. Substrate 2 of the member 1C is coated by a coating 6C. The coating 6C has a multi-layered structure 8C comprising a plurality of first layers 4 and a plurality of intermediate layers 5 alternatingly deposited and the hard carbon layer 7 is deposited onto the multilayered structure. The multi-layered structure 8C has four or more layers. The outermost layer of the multi-layer structure 8C is the intermediate layer 5 which is adjacent to the hard carbon layer 7. The first layer 4 and the intermediate layer 5, and the hard carbon layer 7 constituting the hard film layer 8C are substantially the same as the first layer 4, the intermediate layer 5, and the hard carbon layer 7 described for members 1A and 1B described above. Because the coating 6C has a structure with numerous interfacial structures, the hardness thereof is enhanced and the wear resistance is improved. Therefore, cutting tools and sliding members made of the member 1C have an excellent durability.

The thickness of the each of the plurality of the first layers 4 and each of the plurality of intermediate layers 5 of the multi-layer structure 8C is preferably in the range of 5 nm to 10 µm, and more preferably 100 nm to 2 µm. In some embodiments, the composition of any of the plurality of the first layers 4 of the multi-layer structure 8C may be different from any other of the plurality of the first layers 4. Alternatively, any layer of the plurality of the first layer 4 may be of the same composition as at least one other layer of the plurality of the first layers 4. In some embodiments, the composition of any of the plurality of the intermediate layers 5 of the multi-layer structure 8C may be different from any other of the plurality of the intermediate layers 5. Alternatively, any layer of the plurality of the intermediate layers 5 may be of the same composition as at least one other layer of the plurality of intermediate layers 5. Preferably, the composition, the thickness and the number of layers of the multi-layer structure 8C is set so to reduce internal stress caused by the multiplicity of layers.

Fig. 4 is a schematic sectional view of a member 1D according to a fourth embodiment of the invention. The member 1 D has a structure in which the surface of the substrate 2 is coated by a coating 6D. The coating 6D has a multi-layered structure 8D which is coated with a laminated sequence 10D. The multi-layered structure 8D in which a plurality of the first layers 4 and a plurality of the intermediate layers 5 are alternatingly deposited is similar to the multi-layered structure 8C described in coating 6C.

The laminated sequence 10D has alternating layers of a plurality of the hard carbon layers 7 and a plurality of the intermediate layers 5. The laminated sequence 10D has three or more layers. In some embodiments, the composition and/or thickness of any of the plurality of the intermediate layers 5 of the laminated sequence 10D may be different from any other of the plurality of intermediate layers 5. In the same way, in some embodiments, the composition and/or thickness of any of the plurality of the hard carbon layers 7 of the laminated sequence 10D may be different from any other of the plurality of hard carbon layers 7 of the laminated sequence 10D.

## Claims

1. A coated member comprising a coating and a substrate, the coating comprising at least one intermediate layer and at least one hard carbon layer; wherein:
the hard carbon layer comprises diamond or DLC and forms the outermost layer of the coating;
the intermediate layer comprises a PVD-formed layer having a composition of SiₓC_{1-x-y-z}N_{y}M_{z} (where 0.4 ≤ x ≤ 0.6, 0 ≤ y ≤ 0.1, and 0 ≤ z ≤ 0.2), wherein Si and C are essential components and M is one or more elements selected from the group consisting of: Ti, Zr, Hf, V, Nb, Ta, Cr, Mo, W, Y, B, Al and Ru; and
a half-value width of an SiC peak observed at 34° to 36° of diffraction angle when X-ray diffraction (XRD) is carried by using a CuKα ray is 3° or less.

2. The coated member according to claim 1, wherein the coating comprises a laminated sequence comprising alternating layers of an intermediate layer and a hard carbon layer, the laminated sequence including a plurality of intermediate layers and a plurality of hard carbon layers.

3. The coated member according to claim 2, wherein:
all layers of the plurality of intermediate layers are from 10nm to 10µm; and
all layers of the plurality of hard carbon layers are from 0.1 µm to 50µm, and preferably,
wherein:
at least two layers of the plurality of intermediate layers have different compositions;
and/or
at least two layers of the plurality hard carbon layers have different compositions.

4. The coated member according to claim 1, wherein the coating further comprises at least one first layer comprising one or more metals selected from the group consisting of: Ti, Zr, Hf, V, Nb, Ta, Cr, Mo, W; wherein the innermost layer of the coating is the first layer and wherein the thickness of the first layer is from 5nm to 10µm.

5. The coated member according to claim 4, wherein the at least one first layer further' comprises one or more elements selected from the group consisting of: Si, Al, Y, B, N, and C, or
wherein one or more layers of the at least one first layer comprises two or more sublayers.

6. The coated member according to claim 4, wherein:
the coating comprises a multi-layered structure comprising alternating layers of a first layer and an intermediate layer, the multi-layered structure including a plurality of first layers and a plurality of intermediate layers; and
the outermost layer of the multi-layer structure is one of said intermediate layers.

7. The coated member according to claim 6, wherein:
at least two layers of the plurality of first layers have different compositions; and/or
at least two layers of the plurality of intermediate layers have different compositions; or
wherein all layers of the plurality of first layers are from 5nm to 10µm, or
wherein the innermost layer of the laminated sequence is one of said hard carbon layers.

8. The coated member according to claim 6, wherein:
the coating comprises a laminated sequence comprising alternating layers of an intermediate layer and a hard carbon layer, the laminated sequence including a plurality of intermediate layers and a plurality of hard carbon;
the laminated sequence is over the multi-layered structure; and
the outermost layer of the laminated sequence is one of said hard carbon layers and is also the outermost layer of the coating.

9. The coated member according to claim 1, wherein the member is selected from the group consisting of jigs, wear parts and friction members, or
wherein the member is a cutting tool.

10. The coated member according to claim 1, comprising:
a multi-layered structure over the substrate, the multi-layered structure comprising alternating layers of a first layer and an intermediate layer and including a plurality of first layers and a plurality of intermediate layers; and
a laminated structure atop the multi-layered structure, the laminated structure comprising alternating layers of the intermediate layer and a hard carbon layer and including a plurality of intermediate layers and a plurality of hard carbon layers; wherein:
each of the first layers comprises one or more metals selected from the group consisting of: Ti, Zr, Hf, V, Nb, Ta, Cr, Mo, W, wherein the thickness of each of the first layers is from 5nm to 10µm;
each of the intermediate layers comprises a PVD-formed layer having a composition of SiₓC_{1-x-y-z}N_{y}M_{z} (where 0.4 ≤ x ≤ 0.6, 0 ≤ y ≤ 0.1, and 0 ≤ z ≤ 0.2), wherein Si and C are essential components and M is one or more elements selected from the group consisting of: Ti, Zr, Hf, V, Nb, Ta, Cr, Mo, W, Y, B, Al and Ru; and wherein a half-value width of an SiC peak observed at 34° to 36° of diffraction angle when X-ray diffraction (XRD) is carried by using a CuKα ray is 3° or less;
each of the hard carbon layers comprises diamond or DLC;
the innermost layer of the coating is one of said first layers; and
the outermost layer of the coating is one of said hard carbon layers.

11. A method of making a coated member comprising a substrate and a coating, the method comprising the steps of:
(a) depositing, by means of a PVD method, an intermediate layer over the substrate, the intermediate layer having a composition of SiₓC_{1-x-y-z}N_{y}M_{z} (where 0.4 ≤ x ≤ 0.6, 0 ≤ y ≤ 0.1, and 0 ≤ z ≤ 0.2), where M is one or more elements selected from the group consisting of: Ti, Zr, Hf, V, Nb, Ta, Cr, Mo, W, Y, B, Al and Ru, such that a half-value width of an SiC peak observed at 34° to 36° of diffraction angle when X-ray diffraction (XRD) is carried by using a CuKα ray is 3° or less;
wherein, during PVD deposition, the substrate is kept at a predetermined temperature between 400°C and 800°C and a predetermined bias voltage of -30 V to -300 V is applied to the substrate; and
(b) depositing a hard carbon layer on the intermediate layer, the hard carbon layer comprising diamond or DLC.

12. The method according to claim 11, comprising depositing the intermediate layer by a PVD magnetron sputtering method.

13. The method according to claim 11, further comprising:
prior to carrying out step (a), depositing a first layer over the substrate, wherein the first layer comprises one or more metals selected from the group consisting of Ti, Zr, Hf, V, Nb, Ta, Cr, Mo, W; wherein the thickness of the first layer is from 5nm to 10µm.

14. The method according to claim 13, wherein the at least one first layer further comprises one or more elements selected from the group consisting of Si, Al, Y, B, N and C.

15. The method according to claim 13, further comprising:
after step (a) and before step (b), alternatingly depositing additional first layers and intermediate layer, preferably further comprising:
after step (b), alternatingly depositing additional intermediate layers and hard carbon layers, wherein the final layer deposited is a hard carbon layer.

## Patentansprüche

1. Beschichtetes Teil mit einer Beschichtung und einem Substrat, wobei die Beschichtung mindestens eine Zwischenschicht und mindestens eine Hartkohlenstoffschicht aufweist; wobei:
die Hartkohlenstoffschicht Diamant oder DLC aufweist und die äußerste Schicht der Beschichtung bildet;
die Zwischenschicht eine durch PVD ausgebildete Schicht aufweist, die eine Zusammensetzung aus SiₓC_{1-x-y-z}N_{y}M_{z} hat (wobei 0,4 ≤ x ≤ 0,6, 0 ≤ y ≤ 0,1 und 0 ≤ z ≤ 0,2), wobei Si und C wesentliche Komponenten sind und M ein oder mehrere Elemente sind, die aus der Gruppe ausgewählt sind, die aus Folgendem besteht: Ti, Zr, Hf, V, Nb, Ta, Cr, Mo, W, Y, B, Al und Ru; und
eine Halbwertsbreite eines SiC-Peaks bei einem Beugungswinkel von 34° bis 36°, wenn Röntgenbeugung (XRD) unter Verwendung eines CuKα-Strahls durchgeführt wird, 3° oder weniger beträgt.

2. Beschichtetes Teil nach Anspruch 1, wobei die Beschichtung eine Schichtfolge aufweist, die alternierende Schichten aus einer Zwischenschicht und einer Hartkohlenstoffschicht aufweist, wobei die Schichtfolge mehrere Zwischenschichten und mehrere Hartkohlenstoffschichten aufweist.

3. Beschichtetes Teil nach Anspruch 2, wobei:
alle Schichten der mehreren Zwischenschichten 10 nm bis 10 µm betragen; und
alle Schichten der mehreren Hartkohlenstoffschichten 0,1 µm bis 50 µm betragen, und wobei vorzugsweise:
mindestens zwei Schichten der mehreren Zwischenschichten unterschiedliche Zusammensetzungen haben; und/oder
mindestens zwei Schichten der mehreren Hartkohlenstoffschichten unterschiedliche Zusammensetzungen haben.

4. Beschichtetes Teil nach Anspruch 1, wobei die Beschichtung ferner mindestens eine erste Schicht aufweist, die ein oder mehrere Metalle aufweist, die aus der Gruppe ausgewählt sind, die aus Folgendem besteht: Ti, Zr, Hf, V, Nb, Ta, Cr, Mo, W; wobei die innerste Schicht der Beschichtung die erste Schicht ist und wobei die Dicke der ersten Schicht 5 nm bis 10 µm beträgt.

5. Beschichtetes Teil nach Anspruch 4, wobei die mindestens eine erste Schicht ferner ein oder mehrere Elemente aufweist, die aus der Gruppe ausgewählt sind, die aus Folgendem besteht: Si, Al, Y, B, N und C, oder
wobei eine oder mehrere Schichten der mindestens einen ersten Schicht zwei oder mehr Teilschichten aufweist.

6. Beschichtetes Teil nach Anspruch 4, wobei:
die Beschichtung eine Mehrschichtstruktur aufweist, die alternierende Schichten aus einer ersten Schicht und einer Zwischenschicht aufweist, wobei die Mehrschichtstruktur mehrere erste Schichten und mehrere Zwischenschichten aufweist; und
die äußerste Schicht der Mehrschichtstruktur eine der Zwischenschichten ist.

7. Beschichtetes Teil nach Anspruch 6, wobei:
mindestens zwei Schichten der mehreren ersten Schichten unterschiedliche Zusammensetzungen haben; und/oder
mindestens zwei Schichten der mehreren Zwischenschichten unterschiedliche Zusammensetzungen haben; oder
wobei alle Schichten der mehreren ersten Schichten 5 nm bis 10 µm betragen oder
wobei die innerste Schicht der Schichtfolge eine der Hartkohlenstoffschichten ist.

8. Beschichtetes Teil nach Anspruch 6, wobei:
die Beschichtung eine Schichtfolge aufweist, die alternierende Schichten aus einer Zwischenschicht und einer Hartkohlenstoffschicht aufweist, wobei die Schichtfolge mehrere Zwischenschichten und mehrere Hartkohlenstoffschichten aufweist;
die Schichtfolge auf der Mehrschichtstruktur ist; und
die äußerste Schicht der Schichtfolge eine der Hartkohlenstoffschichten ist und auch die äußerste Schicht der Beschichtung ist.

9. Beschichtetes Teil nach Anspruch 1, wobei das Teil aus der Gruppe ausgewählt ist, die aus Haltevorrichtungen, Verschleißteilen und Reibungsteilen besteht, oder
wobei das Teil ein Schneidwerkzeug ist.

10. Beschichtetes Teil nach Anspruch 1 mit:
einer Mehrschichtstruktur auf dem Substrat, wobei die Mehrschichtstruktur alternierende Schichten aus einer ersten Schicht und einer Zwischenschicht aufweist und mehrere erste Schichten und mehrere Zwischenschichten aufweist; und
einer Schichtstruktur auf der Mehrschichtstruktur, wobei die Schichtstruktur alternierende Schichten aus der Zwischenschicht und einer Hartkohlenstoffschicht aufweist und mehrere Zwischenschichten und mehrere Hartkohlenstoffschichten aufweist; wobei:
jede der ersten Schichten ein oder mehrere Metalle aufweist, die aus der Gruppe ausgewählt sind, die aus Folgendem besteht: Ti, Zr, Hf, V, Nb, Ta, Cr, Mo, W, wobei die Dicke jeder der ersten Schichten 5 nm bis 10 µm beträgt;
jede der Zwischenschichten eine durch PVD ausgebildete Schicht aufweist, die eine Zusammensetzung aus SiₓC_{1-x-y-z}N_{y}M_{z} hat (wobei 0,4 ≤ x ≤ 0,6, 0 ≤ y ≤ 0,1 und 0 ≤ z < 0,2), wobei Si und C wesentliche Komponenten sind und M ein oder mehrere Elemente sind, die aus der Gruppe ausgewählt sind, die aus Folgendem besteht: Ti, Zr, Hf, V, Nb, Ta, Cr, Mo, W, Y, B, Al und Ru; und wobei eine Halbwertsbreite eines SiC-Peaks bei einem Beugungswinkel von 34° bis 36°, wenn Röntgenbeugung (XRD) unter Verwendung eines CuKα-Strahls durchgeführt wird, 3° oder weniger beträgt;
jede der Hartkohlenstoffschichten Diamant oder DLC aufweist;
die innerste Schicht der Beschichtung eine der ersten Schichten ist; und
die äußerste Schicht der Beschichtung eine der Hartkohlenstoffschichten ist.

11. Verfahren zur Herstellung eines beschichteten Teils mit einem Substrat und einer Beschichtung, wobei das Verfahren die folgenden Schritte umfasst:
(a) mittels eines PVD-Verfahrens erfolgendes Aufbringen einer Zwischenschicht auf dem Substrat, wobei die Zwischenschicht eine Zusammensetzung aus SiₓC_{1-x-y-z}N_{y}M_{z} hat (wobei 0,4 ≤ x ≤ 0,6, 0 ≤ y ≤ 0,1 und 0 ≤ z ≤ 0,2), wobei M ein oder mehrere Elemente sind, die aus, der Gruppe ausgewählt sind, die aus Folgendem besteht: Ti, Zr, Hf, V, Nb, Ta, Cr, Mo, W, Y, B, Al und Ru, so dass eine Halbwertsbreite eines SiC-Peaks bei einem Beugungswinkel von 34° bis 36°, wenn Röntgenbeugung (XRD) unter Verwendung eines CuKα-Strahls durchgeführt wird, 3° oder weniger beträgt;
wobei während der PVD-Beschichtung das Substrat auf einer vorbestimmten Temperatur zwischen 400°C und 800°C gehalten wird und eine vorbestimmte Vorspannung von -30 V bis - 300 V an das Substrat angelegt wird; und
(b) Aufbringen einer Hartkohlenstoffschicht auf der Zwischenschicht, wobei die Hartkohlenstoffschicht Diamant oder DLC aufweist.

12. Verfahren nach Anspruch 11, umfassend: Aufbringen der Zwischenschicht durch ein PVD-Magnetronsputterverfahren.

13. Verfahren nach Anspruch 11, ferner umfassend:
vor der Durchführung von Schritt (a) erfolgendes Aufbringen einer ersten Schicht auf dem Substrat, wobei die erste Schicht ein oder mehrere Metalle aufweist, die aus der Gruppe ausgewählt sind, die aus Folgendem besteht: Ti, Zr, Hf, V, Nb, Ta, Cr, Mo, W; wobei die Dicke der ersten Schicht 5 nm bis 10 µm beträgt.

14. Verfahren nach Anspruch 13, wobei die zumindest eine erste Schicht ferner ein oder mehrere Elemente aufweist, die aus der Gruppe ausgewählt sind, die aus Si, Al, Y, B, N und C besteht.

15. Verfahren nach Anspruch 13, ferner umfassend:
nach Schritt (a) und vor Schritt (b) erfolgendes alternierendes Aufbringen zusätzlicher ersten Schichten und Zwischenschichten, vorzugsweise ferner umfassend:
nach Schritt (b) erfolgendes alternierendes Aufbringen zusätzlicher Zwischenschichten und Hartkohlenstoffschichten, wobei die letzte aufgebrachte Schicht eine Hartkohlenstoffschicht ist.

## Revendications

1. Élément revêtu comprenant un revêtement et un substrat, le revêtement comprenant au moins une couche intercalaire et au moins une couche de carbone dur ; où :
la couche de carbone dur comprend du diamant ou du DLC et constitue la couche superficielle du revêtement ;
la couche intercalaire comprend une couche formée par procédé PVD avec la composition SiₓC_{1-x-y-z}N_{y}M_{z}, (où 0,4 ≤x ≤ 0,6, 0 ≤y ≤ 0,1, et 0 ≤ z ≤ 0,2), Si et C étant des composants essentiels et M un ou plusieurs éléments sélectionnés dans le groupe composé de : Ti, Zr, Hf, V, Nb, Ta, Cr, Mo, W, Y, B, Al et Ru ; et une valeur de largeur à mi-hauteur d'un pic SiC observée sous un angle de diffraction entre 34° et 36° quand la diffraction aux rayons X (DX) est exécutée avec un rayon CuK α, étant inférieure ou égale à 3°.

2. Élément revêtu selon la revendication 1, où le revêtement comprend une séquence laminée où alternent des couches intercalaires et de carbone dur, la séquence laminée comprenant une pluralité de couches intercalaires et une pluralité de couches de carbone dur.

3. Élément revêtu selon la revendication 2, où :
toutes les couches de la pluralité de couches intercalaires sont comprises entre 10 nm et 10 µm;
et toutes les couches de la pluralité de couches de carbone dur sont comprises entre 0,1 µm et 50 µm, et préférentiellement où :
au moins deux couches de la pluralité de couches intercalaires ont des compositions différentes ;
et/ou au moins deux couches de la pluralité de couches de carbone dur ont des compositions différentes.

4. Élément revêtu selon la revendication 1, où le revêtement comprend en outre au moins une première couche comprenant un ou plusieurs métaux sélectionnés dans le groupe composé de : Ti, Zr, Hf, V, Nb, Ta, Cr, Mo, W ; où la couche la plus intérieure du revêtement est la première couche et où l'épaisseur de la première couche est comprise entre 5 nm et 10 µm.

5. Élément revêtu selon la revendication 4, où la ou les premières couches comprennent en outre un ou plusieurs éléments sélectionnés dans le groupe composé de : Si, Al, Y, B, N, et C, ou bien
où une ou plusieurs couches de la ou les premières couches comprennent au moins deux sous-couches.

6. Élément revêtu selon la revendication 4, où :
le revêtement comprend une structure multi-couches comprenant des premières couches et des couches intercalaires alternées, la structure multi-couches comprenant une pluralité de premières couches et une pluralité de couches intercalaires ; et où la couche superficielle de la structure multi-couches est une des couches intercalaires.

7. Élément revêtu selon la revendication 6, où :
au moins deux couches de la pluralité de premières couches ont des compositions différentes ; et/ou au moins deux couches de la pluralité de couches intercalaires ont des compositions différentes ; ou bien
où toutes les couches de la pluralité de premières couches sont comprises entre 5 nm et 10 µm, ou bien
où la couche la plus intérieure de la séquence laminée est une des couches de carbone dur.

8. Élément revêtu selon la revendication 6, où :
le revêtement comprend une séquence laminée où alternent des couches intercalaires et
de carbone dur, la séquence laminée comprenant une pluralité de couches intercalaires et une pluralité de couches de carbone dur ;
la séquence laminée est disposée sur la structure multi-couches ; et la couche superficielle de la séquence laminée est une des couches de carbone dur et est également la couche superficielle du revêtement.

9. Élément revêtu selon la revendication 1, où ledit élément est sélectionné dans le groupe composé de gabarits, de pièces d'usure et d'éléments de friction, ou bien où l'élément est un outil de coupe.

10. Elément revêtu selon la revendication 1, comprenant :
une structure multi-couches sur le substrat, la structure multi-couches comprenant des premières couches et des couches intercalaires alternées et comprenant une pluralité de premières couches et une pluralité de couches intercalaires ; et
une structure laminée sur la structure multi-couches, la structure laminée comprenant des couches intercalaires et de carbone dur alternées et comprenant une pluralité de couches intercalaires et une pluralité de couches de carbone dur, où :
chacune des premières couches comprend un ou plusieurs métaux sélectionnés dans le groupe composé de : Ti, Zr, Hf, V, Nb, Ta, Cr, Mo, W, l'épaisseur de chacune des premières couches étant comprise entre 5 nm et 10 µm ;
chacune des couches intercalaires comprend une couche formée par procédé PVD avec la composition SiₓC_{1-x-y-z}N_{y}M_{z}, (où 0,4 ≤x ≤ 0,6, 0 ≤y ≤ 0,1, et 0 ≤ z ≤ 0,2), Si et C étant des composants essentiels et M un ou plusieurs éléments sélectionnés dans le groupe composé de : Ti, Zr, Hf, V, Nb, Ta, Cr, Mo, W, Y, B, Al et Ru ; et une valeur de largeur à mi-hauteur d'un pic SiC observée sous un angle de diffraction entre 34° et 36° quand la diffraction aux rayons X (DX) est exécutée avec un rayon CuK α, étant inférieure ou égale à 3° ;
chacune des couches de carbone dur comprend du diamant ou du DLC ;
la couche la plus intérieure du revêtement est une des premières couches ; et
la couche superficielle du revêtement est une des couches de carbone dur.

11. Procédé de production d'un élément revêtu comprenant un substrat et un revêtement, ledit procédé comprenant les étapes suivantes :
(a) dépôt au moyen d'un procédé PVD d'une couche intercalaire sur le substrat, la couche intercalaire ayant la composition SiₓC_{1-x-y-z}N_{y}M_{z}, (où 0,4 ≤x ≤ 0,6, 0≤y ≤ 0,1, et 0 ≤ z ≤ 0,2), où M est un ou plusieurs éléments sélectionnés dans le groupe composé de: Ti, Zr, Hf, V, Nb, Ta, Cr, Mo, W, Y, B, Al et Ru, de telle manière qu'une valeur de largeur à mi-hauteur d'un pic SiC observée sous un angle de diffraction entre 34° et 36° quand la diffraction aux rayons X (DX) est exécutée avec un rayon CuK α, soit inférieure ou égale à 3° ;
où, pendant le dépôt PVD, le substrat est maintenu à température prédéterminée entre 400°C et 800 °C et une tension de polarisation prédéterminée de -30 V à -300 V est appliquée au substrat ; et
(b) dépôt d'une couche de carbone dur sur la couche intercalaire, la couche de carbone dur comprenant du diamant ou du DLC.

12. Procédé selon la revendication 11, comprenant le dépôt de la couche intercalaire au moyen d'un procédé de dépôt PVD par pulvérisation à magnétron.

13. Procédé selon la revendication 11, comprenant en outre :
préalablement à l'exécution de l'étape (a), le dépôt d'une première couche sur le substrat, la première couche comprenant un ou plusieurs métaux sélectionnés dans le groupe composé de Ti, Zr, Hf, V, Nb, Ta, Cr, Mo, W ; l'épaisseur de la première couche étant comprise entre 5 mn et 10 µm.

14. Procédé selon la revendication 13, où la ou les premières couches comprennent en outre un ou plusieurs éléments sélectionnés dans le groupe composé de Si, Al, Y, B, N et C.

15. Procédé selon la revendication 13, comprenant en outre :
après l'étape (a) et avant l'étape (b), dépôt de premières couches et de couches intercalaires additionnelles alternées, et comprenant en outre préférentiellement :
après l'étape (b), dépôt de couches intercalaires et de couches de carbone dur additionnelles alternées, la couche finale déposée étant une couche de carbone dur.
